# EUROPEAN PATENT SPECIFICATION

(11) **EP 3 029 083 B1**
(45) Date of publication and mention of the grant of the patent: **09.08.2017**
(21) Application number: 15197520.8
(22) Date of filing: 02.12.2015
(51) Int. Cl.: C08G 59/24, C08G 59/42, C08K 3/00, H01L 23/28

(54) **RESIN COMPOSITION FOR SEMICONDUCTOR ENCAPSULATION AND SEMICONDUCTOR ENCAPSULATION METHOD USING SAME**
HARZZUSAMMENSETZUNG ZUR VERKAPSELUNG VON HALBLEITERN UND HALBLEITERVERKAPSELUNGSVERFAHREN DAMIT
COMPOSITION DE RÉSINE POUR ENCAPSULATION DE SEMI-CONDUCTEUR ET PROCÉDÉ D'ENCAPSULATION DE SEMI-CONDUCTEUR L'UTILISANT

(30) Priority: 02.12.2014 JP 2014244154
(43) Date of publication of application: 08.06.2016
(73) Proprietor: Shin-Etsu Chemical Co., Ltd., Tokyo 100-0004 (JP)
(72) Inventor: KUSHIHARA, Naoyuki, Gunma, 3790224 (JP); SUMITA, Kazuaki, Gunma, 3790224 (JP)
(74) Representative: Peters, Hajo

(56) References cited:
- EP-A2- 2 546 275
- DATABASE WPI Week 199926 Thomson Scientific, London, GB; AN 1999-308169 XP002755820, & JP H11 106474 A (HITACHI CHEM CO LTD) 20 April 1999 (1999-04-20)

## Description

### Field of the invention

The present invention relates to a resin composition for semiconductor encapsulation; and a semiconductor encapsulation method using the same.

### Background art

In recent years, significantly thin encapsulation resins have been used due to the fact that electronic parts have become smaller and thinner in the field of semiconductor packaging or the like. Conventionally, electronic parts such as semiconductors were encapsulated through transfer molding using solid epoxy resin compositions. However, it is required that the resin be able to flow to a narrow space(s) in the case where resin encapsulation is performed through transfer molding to obtain a thin package. That is, in such case, there exists a concern that wire deformation may occur. For these reasons, it is perceived as such that a filling failure will easily occur as an encapsulation area becomes large.

Here, in recent years, compression molding using a liquid epoxy resin composition has been employed to encapsulate thin packages and wafer level packages where large areas need to be encapsulated. As compared to the case where a solid epoxy resin composition is used, using a liquid epoxy resin composition in compression molding decreases the viscosity of the epoxy resin to an extremely low level at the time of performing resin encapsulation molding. Therefore, wire deformation shall not occur easily under such circumstance, and it is thus expected that a large area can be encapsulated at one time.

However, a warpage occurring after performing resin encapsulation molding is a significant problem in the case where a large area(s) are to be encapsulated at one time. In order to solve such problem, there has been known a method for lowering a thermal stress after performing resin encapsulation molding, by adding a large amount of an inorganic filler to a liquid epoxy resin composition (e.g. JP-A-Hei 8-41293, JP-A-2002-121260 and JP-A-2007-19751). As a result of adding a large amount of an inorganic filler to a liquid epoxy resin composition in such manner, although the thermal stress after performing resin encapsulation molding will decrease, the viscosity of the liquid epoxy resin composition will increase such that the composition will no longer remain a liquid composition. That is, in the case of a liquid epoxy resin composition to which a large amount of an inorganic filler has been added, wire sweep as a type of wire deformation and filling failures may occur easily, and resin supply is difficult at the time of production.

Further, in the midst of the trend of promoting the technical innovation of semiconductor device packaging, the amounts of the heat generated by semiconductor elements have now increased due to semiconductor devices with higher performance and higher integration. For this reason, junction temperatures are now as high as 150 to 175°C. While semiconductor devices have employed structures with which heat can be easily released therefrom as a whole, it is required that a resin for encapsulation itself also have a thermal resistance property (JP-A-2004-204082).

Therefore, as for an epoxy resin composition used to encapsulate electronic parts through compression molding, there is anticipated a liquid epoxy resin composition containing a large amount of an inorganic filler while still exhibiting a high fluidity; exhibiting a small warpage after performing resin encapsulation molding; and having a high thermal resistance.

### Prior art documents

### Patent documents

[Patent document 1] JP-A-Hei 8-41293
[Patent document 2] JP-A-2002-121260
[Patent document 3] JP-A-2007-19751
[Patent document 4] JP-A-2004-204082

### SUMMARY OF THE INVENTION

Accordingly, it is an object of the present invention to provide a resin composition for semiconductor encapsulation being fluid and exhibiting a low viscosity at a room temperature; having a high glass-transition temperature; and capable of restricting a warpage of a molded product obtained through resin encapsulation. Further, it is also an object of the present invention to provide a semiconductor encapsulation method with which a small warpage is exhibited even after performing resin encapsulation molding i.e. a wafer level package-encapsulation method in particular. Means to solve the problem

In view of the abovementioned facts and as a result of their dedications to the related studies, the inventors of the present invention completed the invention by obtaining a resin composition for semiconductor encapsulation that meets the aforementioned objectives.

That is, the invention is as follows.
<1> A resin composition for semiconductor encapsulation, including:
   (A) an alicyclic epoxy compound represented by the following formula 1: 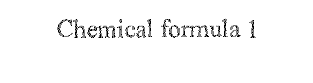 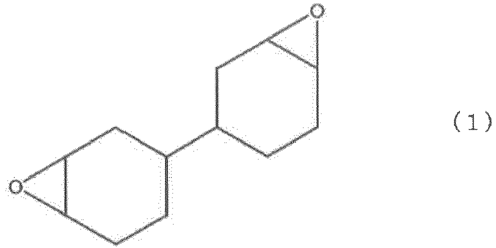
   (B) an epoxy resin in the form of a liquid at a room temperature, the epoxy resin being an epoxy resin other than the alicyclic epoxy compound represented by the formula 1;
   (C) an acid anhydride curing agent;
   (D) a curing accelerator; and
   (E) an inorganic filler, wherein
   the component (A) is added in an amount of 30 to 95 parts by mass with respect to 100 parts by mass of all the epoxy resins in the total amount of the resin composition, and the component (E) is contained in the total amount of the resin composition by an amount of 80 to 95 % by mass.
<2> The resin composition for semiconductor encapsulation according to <1>, wherein the component (B) is a liquid epoxy resin that does not have a siloxane bond.
<3> The resin composition for semiconductor encapsulation according to <1> or <2>, wherein the component (B) is at least one liquid epoxy resin selected from the group consisting of a liquid bisphenol A-type epoxy resin; a liquid bisphenol F-type epoxy resin; a liquid naphthalene-type epoxy resin; a liquid aminophenol-type epoxy resin; a liquid hydrogenated bisphenol-type epoxy resin; a liquid alcohol ether-type epoxy resin; a liquid cyclic aliphatic epoxy resin; a liquid fluorene-type epoxy resin and a liquid alicyclic epoxy resin represented by the following formula 2: 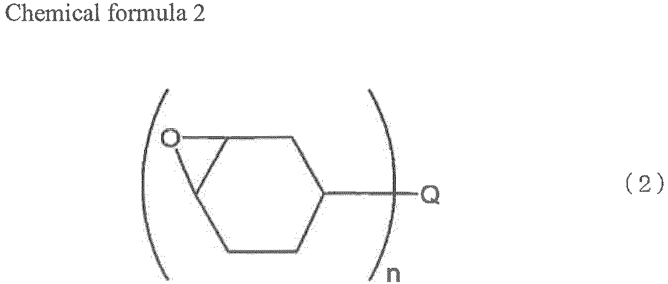 wherein n satisfies n ≥ 2, and Q represents at least one group selected from an n-valent hydrocarbon group having 1 to 30 carbon atoms, an ether bond, an ester bond, a carbonate bond, an amide bond, a carbonyl group and a cyclohexene oxide residue.
<4> The resin composition for semiconductor encapsulation according to <3>, wherein the Q in the formula 2 contains a divalent hydrocarbon group and an ester bond.
<5> The resin composition for semiconductor encapsulation according to <1>, wherein the component (C) is in the form of a liquid at a room temperature.
<6> The resin composition for semiconductor encapsulation according to <1> to <5>, wherein a cured product of the resin composition for semiconductor encapsulation exhibits a glass-transition temperature of 170°C to 300°C.
<7> A wafer level package-encapsulation method including a step of performing encapsulation through compression-molding, using the resin composition for semiconductor encapsulation as set forth in <1> to <6>.

The resin composition of the present invention is fluid and exhibits a low viscosity at a room temperature, even when containing a large amount of an inorganic filler. Therefore, this resin composition is suitable for encapsulating various types of semiconductors. Further, a cured product of such resin composition has a high glass-transition temperature, and is capable of restricting the warpage of a molded product obtained through resin encapsulation.

### BRIEF DESCRIPTION OF THE DRAWINGS

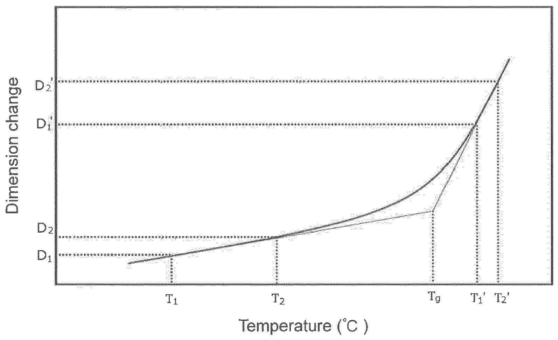

FIG.1 is a diagram showing a method for determining a glass-transition temperature in working examples.

### DETAILED DESCRIPTION OF THE INVENTION

The present invention is described in detail hereunder. In the present invention, a "room temperature" refers to a temperature of a range of 25°C to 35°C unless otherwise noted.

### Component (A)

A component (A) is an alicyclic epoxy compound represented by the following formula (1).

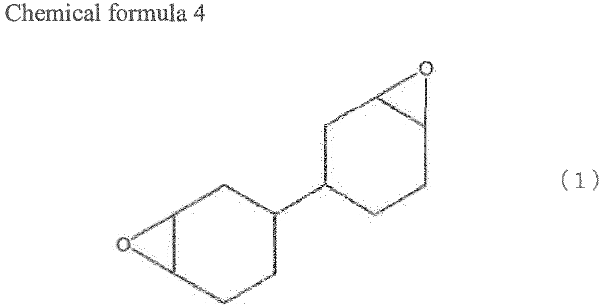

The alicyclic epoxy compound is a compound where two cyclohexene oxide groups as alicyclic epoxy groups are singly bonded to each other. Each cyclohexene oxide group includes an aliphatic ring; and an epoxy group having an oxygen atom and two carbon atoms adjacent to the aliphatic ring. That is, used is a 3,4,3',4'-diepoxybicyclohexyl, a commercially available example of which being "CELLOXIDE 8000" (by DAICEL CORPORATION).

The alicyclic epoxy compound as the component (A) is contained in an amount of 30 to 95 parts by mass, preferably 40 to 90 parts by mass, more preferably 50 to 90 parts by mass, with respect to 100 parts by mass of a total amount of all the epoxy resins. If the component (A) is contained in an amount smaller than 30 parts by mass, an epoxy resin composition may not be able to be kneaded, and a glass-transition temperature may decrease, for instance. Further, when the amount of the component (A) contained is greater than 95 parts by mass, the cured product of the resin composition will become fragile such that cracks may occur at the time of performing molding. Furthermore, it is preferred that the component (A) be contained in an amount of 0.5 to 7.5% by mass, more preferably 0.5 to 5% by mass, particularly preferably 1.0 to 4.5% by mass with respect to the total amount of the resin composition.

### Component (B)

A component (B) used in the present invention is an epoxy resin other than the alicyclic epoxy compound represented by the formula (1). The epoxy resin as the component (B) is in the form of a liquid at the room temperature (25°C). Examples of such component (B) include a liquid bisphenol A-type epoxy resin, a liquid bisphenol F-type epoxy resin, a liquid naphthalene-type epoxy resin, a liquid aminophenol-type epoxy resin, a liquid hydrogenated bisphenol-type epoxy resin, a liquid alcohol ether-type epoxy resin, a liquid cyclic aliphatic epoxy resin, a liquid fluorene-type epoxy resin and a liquid alicyclic epoxy resin represented by the following formula (2):

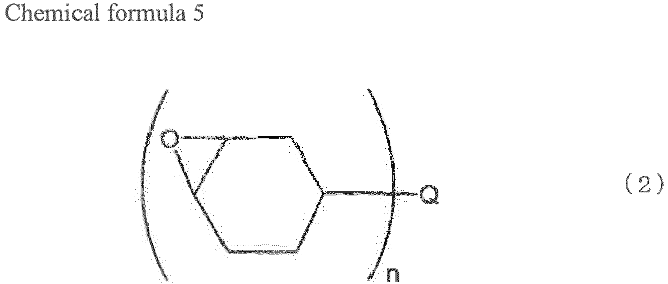

(In the formula (2), n satisfies n≥2; Q represents at least one group selected from an n-valent hydrocarbon group having 1 to 30 carbon atoms, an ether bond, an ester bond, a carbonate bond, an amide bond, a carbonyl group and a cyclohexene oxide residue.) Not only one kind, but two or more kinds of these epoxy resins may be used in combination.

Examples of the hydrocarbon group in the above formula (2) include a linear or branched alkylene group having 1 to 30 carbon atoms; and a divalent alicyclic hydrocarbon group. Here, examples of such linear or branched alkylene group having 1 to 30 carbon atoms include a methylene group, a methylmethylene group, a dimethylmethylene group, an ethylene group, a propylene group and a trimethylene group. Moreover, examples of the divalent alicyclic hydrocarbon group include divalent cycloalkylene groups (including cycloalkylidene groups) such as a 1,2-cyclopentylene group, a 1,3-cyclopentylene group, a cyclopentylidene group, a 1,2-cyclohexylene group, a 1,3-cyclohexylene group, a 1,4-cyclohexylene group and a cyclohexylidene group.

Typical examples of the liquid alicyclic epoxy resin represented by the above formula (2) include compounds represented by the following formulas (I-1) to (I-9).

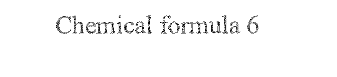

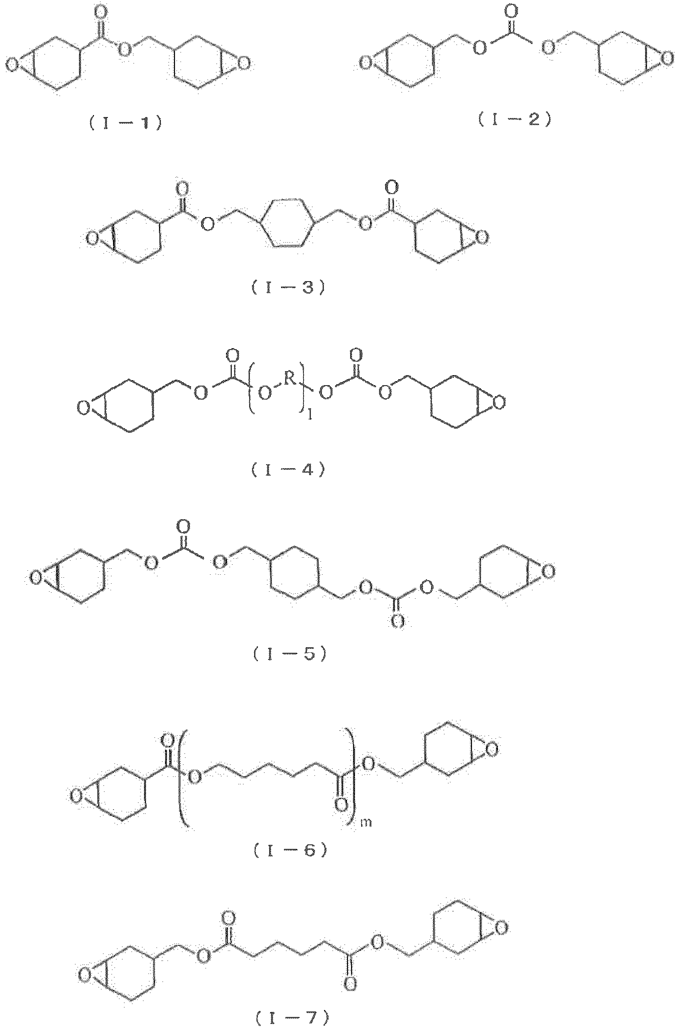

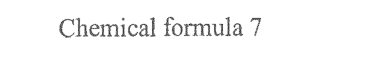

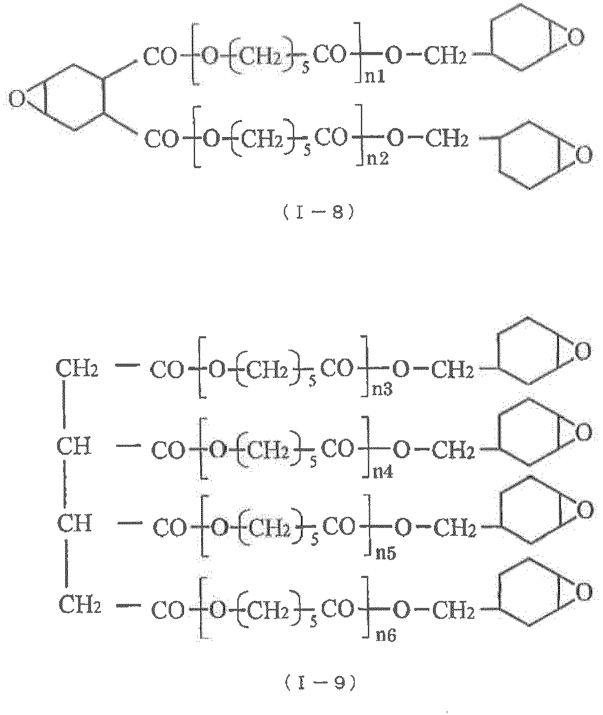

(In the above formulas (I-1) to (I-9), each of 1, m and n1 to n6 represents a number of 1 to 30; R represents an alkylene group having 1 to 8 carbon atoms, examples of which including a linear or branched alkylene group such as a methylene group, an ethylene group, a propylene group, an isopropylene group, a butylene group, an isobutylene group, an s-butylene group, a pentylene group, a hexylene group, a heptylene group and an octylene group.) Examples of these compounds include commercially available products such as "CELLOXIDE 2021P" and "CELLOXIDE 2081" by DAICEL CORPORATION.

It is preferred that the liquid epoxy resin as the component (B) be contained in an amount of 5 to 70 parts by mass, more preferably 10 to 60 parts by mass, particularly preferably 10 to 50 parts by mass with respect to 100 parts by mass of the total amount of all the epoxy resins.

### Component (C)

There are no particular restrictions on an acid anhydride curing agent as a component (C) used in the present invention, as long as it is capable of curing the epoxy resin component. It is preferred that the curing agent be that in the form of a liquid either at the room temperature or when dissolved in the component (A). Examples of the component (C) include 3,4-dimethyl-6-(2-methyl-1-propenyl)-1,2,3,6-tetrahydro phthalic anhydride; 1-isopropyl-4-methyl-bicyclo[2.2.2]oct-5-ene-2,3-dicarboxylic anhydride; methyltetrahydro phthalic anhydride; methylhexahydro phthalic anhydride; hexahydro phthalic anhydride; methylhimic anhydride; pyromellitic dianhydride; maleated allo-ocimene; benzophenonetetracarboxylic dianhydride; 3,3',4,4'-biphenyl-tetra-bis-benzophenonetetracarboxylic dianhydride; (3,4-dicarboxyphenyl) ether dianhydride; bis (3,4-dicarboxyphenyl) methane dianhydride; and 2,2-bis (3,4-dicarboxyphenyl) propane dianhydride. In fact, not only one kind, but two or more kinds of these compounds may be used in combination.

The component (C) is contained in an amount effective to cure the components (A) and (B). Further, the amount of the component (C) is preferably determined in such a way that an equivalent ratio of the carboxylic groups derived from the acid anhydride groups (-CO-O-CO-) in the curing agent to the epoxy groups in the epoxy resin falls into a range of 0.5 to 1.5. An amount below such lower limit causes the unreacted epoxy groups to remain such that the glass-transition temperature may decrease, and an adhesion may decrease as well. An amount greater than the above upper limit causes a cured product to become hard and fragile such that cracks may occur at the time of performing reflow or a temperature cycle test.

### Component (D)

In addition, a curing accelerator as a component (D) used in the present invention is added to promote a curing reaction between the epoxy resin and the curing agent. There are no particular restrictions on the component (D), as long as it is capable of promoting such curing reaction. Examples of the component (D) include phosphorous compounds such as triphenylphosphine, tributylphosphine, tri (p-methylphenyl) phosphine, tri (nonylphenyl) phosphine, triphenylphosphine·triphenylborane and tetraphenylphosphine·tetraphenylborate; tertiary amine compounds such as triethylamine, benzyldimethylamine, α-methylbenzyldimethylamine and 1,8-diazabicyclo [5.4.0] undecene-7; and imidazole compounds such as 2-methylimidazole, 2-phenylimidazole and 2-phenyl-4-methylimidazole.

The curing accelerator is used in an amount effective to accelerate the curing reaction between the epoxy resin and the curing agent. It is preferred that the amount of the curing accelerator be 0.1 to 15 parts by mass, more preferably 0.5 to 10 parts by mass, particularly preferably 1 to 10 parts by mass with respect to 100 parts by mass of a total of the components (A), (B) and (C).

### Component (E)

An inorganic filler as a component (E) used in the present invention is added to control a warpage occurring after performing resin encapsulation molding. Examples of such inorganic filler include silicas such as a molten silica, a crystalline silica and a cristobalite; an alumina; a silicon nitride; an aluminum nitride; a boron nitride; a titanium oxide; a glass fiber; and a magnesium oxide. The average particle diameters and shapes of these inorganic fillers can be appropriately determined depending on the intended use. For example, it is preferred that a molten silica be used as the inorganic filler and that such molten silica have a spherical shape, if achieving a thermal expansion coefficient of the resin composition that is close to that of silicon.

As for these inorganic fillers, it is preferred that the impurities extracted therefrom under a condition of sample 5 g / water 50 g at 120°C and 2.1 atm exhibit a chloride ion concentration of not higher than 10 ppm and a sodium ion concentration of not higher than 10 ppm, from the perspective of the moisture resistance property of a semiconductor device.

Here, it is preferred that the inorganic filler be previously surface-treated with a coupling agent such as a silane coupling agent and a titanate coupling agent, for the purpose of improving a bond strength between the epoxy resin and the inorganic filler. Examples of such coupling agent include epoxy silanes such as γ-glycidoxypropyltrimethoxysilane, γ-glycidoxypropylmethyldiethoxysilane and β-(3,4-epoxycyclohexyl) ethyltrimethoxysilane; amino silanes such as N-β (aminoethyl)-γ-aminopropyltrimethoxysilane, γ-aminopropyltriethoxysilane and N-phenyl-γ-aminopropyltrimethoxysilane; and mercapto silanes such as γ-mercapto silane. There are no particular restrictions on the amount of the coupling agent added and a method of surface treatment.

The inorganic filler is added in an amount of 80 to 95% by mass, preferably 86 to 95% by mass, more preferably 86 to 94.5% by mass with respect to the total amount of the resin composition. When the inorganic filler is added in an amount of less than 80% by mass, the resin composition will exhibit a larger thermal expansion coefficient such that a significant warpage may occur in a molded product obtained after encapsulation. Further, when the inorganic filler is added in an amount of more than 95% by mass, a fluidity at the time of performing molding may decrease significantly.

### Other additives

Although the resin composition of the present invention is obtained by blending the components (A) to (E) of the given amounts, other additives may also be added if necessary, provided that these additives do not hinder the purposes and effects of the present invention. Examples of these additives include a mold release agent, a flame retardant, an ion trapping agent, an antioxidant, an adhesion imparting agent, a low stress agent and a coloring agent.

A mold release agent is added to improve a mold releasability from a mold. In fact, all kinds of known mold release agents can be used. Examples of such mold release agent include a carnauba wax; a rice wax; a candelilla wax; polyethylene; an oxidized polyethylene; polypropylene; a montanic acid; a stearic acid; a stearic acid ester; a stearic acid amide; and a montan wax as an ester compound of a montanic acid with, for example, a saturated alcohol, 2-(2-hydroxyethylamino) ethanol, ethylene glycol or glycerin.

A flame retardant is added to impart a flame retardant property. In fact, all kinds of known flame retardants can be used, and there are no particular restrictions on such flame retardant. Examples of such flame retardant include a phosphazene compound, a silicone compound, a zinc molybdate-supported talc, a zinc molybdate-supported zinc oxide, an aluminum hydroxide, a magnesium hydroxide and a molybdenum oxide.

An ion trapping agent is added to trap ion impurities contained in the resin composition, and avoid thermal and moisture absorption degradations accordingly. In fact, all kinds of known ion trapping agents can be used, and there are no particular restrictions on such ion trapping agent. Examples of such ion trapping agent include hydrotalcites, a bismuth hydroxide compound and a rare earth oxide.

The amount of these additives added varies depending on the intended use of the resin composition. However, it is preferred that the additives be added in an amount of not more than 10% by mass with respect to the total amount of the resin composition.

### Production method of resin composition

The resin composition of the present invention can be produced through the following method.

For example, the alicyclic epoxy resin (A), the liquid epoxy resin (B), the acid anhydride curing agent (C), the curing accelerator (D) and the inorganic filler (E) are either simultaneously or independently mixed, stirred, melted and/or dispersed while performing a heat treatment if necessary, thereby obtaining the resin composition of the components (A) to (E). It is preferred that the resin composition of the components (A) to (E) be obtained by adding the component (D) to a mixture of the components (A) to (C) and the component (E), and then stirring, melting and/or dispersing the same. Further, according to intended use, at least one of an adhesion aid, a flexibility imparting agent, a mold release agent, a flame retardant, an ion trapping agent and the like may be added to the resin composition of the components (A) to (E) as the other additive(s) mentioned above. A resin composition may then be obtained by mixing such additive(s) and the resin composition of the components (A) to (E). Not only one kind, but two or more kinds of these components may be used in combination.

There are no particular restrictions on the devices for performing mixing, stirring and dispersing to produce the resin composition of the present invention. Specifically, there can be used a grinding machine equipped with a mixing and a heating devices, a twin-roll mill, a triple-roll mill, a ball mill, a planetary mixer or a mass-colloider. These devices may also be appropriately used in combination. Semiconductor encapsulation using the resin composition of the present invention thus obtained may be performed through a conventional molding method such as transfer molding, compression molding and injection molding; or through a cast method.

If employing these molding methods, it is desired that the resin composition for semiconductor encapsulation of the present invention as a heat-curable composition be molded under a condition where a molding temperature is 120 to 150°C, and a heating time is 45 to 600 seconds; and that post curing be performed at 150 to 200°C for 2 to 16 hours after molding.

As for a cured product of the resin composition for semiconductor encapsulation of the present invention that has been molded through such molding method, the glass-transition temperature thereof is 170 to 300°C, preferably 180 to 250°C, more preferably 200 to 230°C.

The resin composition for semiconductor encapsulation of the present invention thus obtained exhibits a high fluidity at the time of performing resin encapsulation molding, thereby making it possible to restrict a filling failure occurring in a narrow section(s). Moreover, since the resin composition of the present invention exhibits a high thermal resistance and a small thermal expansion coefficient after being cured thermally, the warpage of a resin-encapsulated portion formed on a wafer can be minimized.

### Working example

The present invention is described in detail hereunder with reference to working and comparative examples. However, the present invention is not limited to the following working examples. Here, the notation "parts" in each example all refers to "parts by mass." As for working examples 1 to 12 and reference examples 1 to 3, the resin compositions for semiconductor encapsulation were obtained by blending together the components shown in Table 1 at the ratios shown therein, and then using a triple roll mill to perform kneading in a homogenous manner. As for comparative examples 1 to 10, the resin compositions for semiconductor encapsulation were obtained by blending together the components shown in Table 2 at the ratios shown therein, and then using a triple roll mill to perform kneading in a homogenous manner. Particularly, the ingredients used in the working and comparative examples are as follows. In Table 1 and Table 2, the amounts of the ingredients are expressed as parts by mass.

### Components used

### (A) Alicyclic epoxy compound (single bond)

Alicyclic epoxy compound (A): Alicyclic epoxy compound (CELLOXIDE 8000 by DAICEL CORPORATION) represented by the following formula (1):

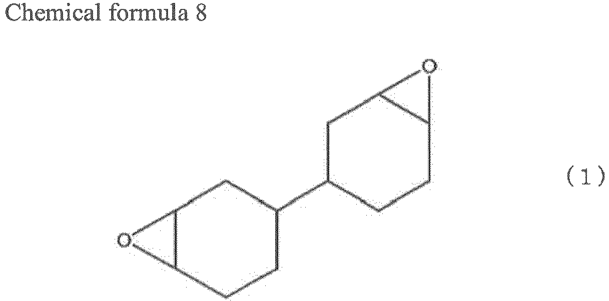

### (B) Liquid epoxy resin

(1) Liquid epoxy resin (B1): Naphthalene-type epoxy resin (HP4032D by DIC Corporation)
(2) Liquid epoxy resin (B2): Trifunctional epoxy resin (EP630 by Mitsubishi Chemical Corporation)
(3) Liquid epoxy resin (B3): Bisphenol A-type epoxy resin (EPIKOTE 828 by Mitsubishi Chemical Corporation)
(4) Liquid epoxy resin (B4): Bisphenol F-type epoxy resin (YDF-8125 by NIPPON STEEL & SUMIKIN CHEMICAL Co., Ltd.)
(5) Liquid epoxy resin (B5): Alicyclic epoxy compound (CELLOXIDE 2021P by DAICEL CORPORATION) represented by the following formula (I-1)

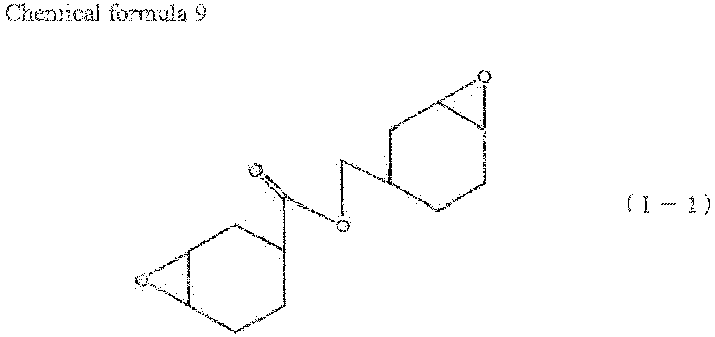

### (C) Acid anhydride curing agent

(1) Acid anhydride curing agent (C1): (RIKACID MH by New Japan Chemical Co., Ltd.)
(2) Acid anhydride curing agent (C2): (RIKACID MH700 by New Japan Chemical Co., Ltd.)

### (D) Curing accelerator: Microcapsule-type latent curing accelerator (NOVACURE HX3088 by Asahi Kasei E-materials Corporation)

### (E) Inorganic filler: Molten spherical silica of an average particle diameter of 14 µm (by Tatsumori Ltd.)

### (F) Other components

(1) Silane coupling agent (γ-glycidoxypropyltrimethoxysilane, KBM-403 by Shin-Etsu Chemical Co., Ltd.)
(2) Pigment ( Carbon black 3230MJ by Mitsubishi Chemical Corporation)

### Evaluation

Each composition obtained was tested through the following evaluation methods.

### (1) Viscosity

An E-type viscometer was used to measure a value obtained 2 minutes after setting a specimen of each composition, at a measurement temperature of 25°C and in accordance with JIS Z8803.

### (2) Measurement of glass-transition temperature

Each of the cured products obtained in the working and comparative examples was processed into a specimen of a size of 5 × 5 × 15 mm, followed by setting the specimen thus prepared into a thermal dilatometer TMA 8140C (by Rigaku Corporation). A temperature program was set as such that the temperature rose at a rate of 5°C/ min, and a constant load of 19.6 mN was applied to the specimen. Changes in the dimensions of the specimen were then measured as the temperature rose from 25 to 300°C. A Correlation between such changes in dimensions and temperatures was later plotted in a graph. The glass-transition temperatures in the working, reference and comparative examples were obtained through a determination method described below, based on the graph showing the correlation between the changes in dimensions and the temperatures. The glass-transition temperatures thus obtained are shown in Table 1 and Table 2.

### Determination method of glass-transition temperature

In Fig.1, T₁ and T₂ are two arbitrary temperature points from which a tangent line to a dimension change-temperature curve can be drawn at temperatures that are not higher than a temperature at an inflection point. Meanwhile, T₁' and T₂' are two arbitrary temperature points from which a similar tangent line can be drawn at temperatures not lower than the temperature at the inflection point. Dimension changes at T₁ and T₂ are respectively denoted by D₁ and D₂, whereas dimension changes at T₁' and T₂' are respectively denoted by D₁' and D₂'. Here, an intersection point between a straight line connecting point (T₁, D₁) and point (T₂, D₂) and a straight line connecting (T₁', D₁') and (T₂', D₂') is determined as a glass-transition temperature (Tg).

### (3) Thermal expansion coefficient (CTE1)

Thermal expansion coefficients were calculated based on the measured data regarding the correlations between the temperatures and the changes in the dimensions of the specimens. Such measured data were those obtained at the time of measuring the glass-transition temperatures under the aforementioned conditions.

### (4) Warpage measurement

A compression-molding product of the liquid resin composition was prepared as follows. That is, there were used a wafer of a size of 8 inch / 200 µm thick; and a wafer molding system (MZ407-1 by ASPIC YAMADA CORPORATION) where a resin thickness was set to 400 µm. Here, compression molding was performed at 120°C for a compression period of 600 seconds, followed by completely curing (post-curing) the compression-molded product under a condition of 180°C / 1 hour. The completely cured product was then subjected to a warpage measurement in the following manner. That is, the completely cured product was later placed horizontally under the room temperature to measure a displacement thereof in a height direction. Here, the warpage was obtained by reading a numerical value indicating the largest displacement. The results thereof are shown in Table 1 and Table 2.

**Table 1**

| | | | | | | | | | | Reference | | Reference | Reference | | | |
|---|---|---|---|---|---|---|---|---|---|---|---|---|---|---|---|---|
| | | | | | | | | | | Example 1 | | Example 2 | Example 3 | | | |
| | Equivalent amount | Working example 1 | Working example 2 | Working example 3 | Working example 4 | Working example 5 | Working example 6 | Working example 7 | Working example 8 | | Working example 9 | | | Working example 10 | Working example 11 | Working example 12 |
| Epoxy resin (A) | 100 | 32.6 | 32.6 | 32.6 | 32.6 | 32.6 | 26.5 | 26.5 | 19.8 | 12.5 | 17.7 | 10.6 | 10.8 | 26.7 | 27.3 | 26.1 |
| Epoxy resin (B 1) | 150 | 3.6 | 3.6 | 3.6 | 3.6 | 3.6 | 11.4 | 11.4 | 19.8 | 29.1 | - | - | - | - | - | - |
| Epoxy resin (B 2) | 100 | - | - | - | - | - | - | - | - | - | 17.7 | 24.8 | 25.2 | - | - | - |
| Epoxy resin (B 3) | 189 | - | - | - | - | - | - | - | - | - | - | - | - | 11.7 | - | - |
| Epoxy resin (B 4) | 160 | - | - | - | - | - | - | - | - | - | - | - | - | - | 11.5 | - |
| Epoxy resin (B 5) | 134 | - | - | - | - | - | - | - | - | - | - | - | - | - | - | 11.2 |
| Acid anhydride curing agent (C 1 ) | 168 | 60.8 | 60.8 | 60.8 | 60.8 | 60.8 | 59.1 | 59.1 | 57.4 | 55.4 | 61.5 | 61.5 | - | 58.8 | 58.1 | 59.7 |
| Acid anhydride curing agent (C 2) | 164 | - | - | | - | - | - | - | - | - | - | - | 60.9 | - | - | - |
| Curing accelerator (D) | | 3 | 3 | 3 | 3 | 3 | 3 | 3 | 3 | 3 | 3 | 3 | 3 | 3 | 3 | 3 |
| Inorganic filler (E) | | 408 | 747 | 916 | 1171 | 1598 | 747 | 1171 | 747 | 747 | 747 | 747 | 747 | 747 | 747 | 747 |
| Adhesion aid | | 1.5 | 1.5 | 1.5 | 1.5 | 1.5 | 1.5 | 1.5 | 1.5 | 1.5 | 1.5 | 1.5 | 1.5 | 1.5 | 1.5 | 1.5 |
| Pigment | | 0.5 | 0.5 | 0.5 | 0.5 | 0.5 | 0.5 | 0.5 | 0.5 | 0.5 | 0.5 | 0.5 | 0.5 | 0.5 | 0.5 | 0.5 |
| Inorganic filler (E) % by mass | | 80 | 88 | 90 | 92 | 94 | 88 | 92 | 88 | 88 | 88 | 88 | 88 | 88 | 88 | 88 |
| | | | | | | | | | | | | | | | | |
| Viscosity | Pa · s | 12 | 35 | 80 | 270 | 800 | 45 | 450 | 70 | 120 | 45 | 60 | 80 | 110 | 80 | 30 |
| Tg | °C | 235 | 230 | 230 | 230 | 230 | 210 | 210 | 200 | 180 | 210 | 185 | 190 | 200 | 200 | 225 |
| CTE1 | CTE1 | 17 | 10 | 8 | 6.5 | 5 | 9 | 6 | 10 | 10 | 10 | 10 | 10 | 10 | 10 | 12 |
| Wafer warpage | mm | 46 | 24 | 18 | 12 | 7 | 19 | 12 | 22 | 21 | 21 | 23 | 22 | 21 | 23 | 20 |

**Table 2**

| | Equivalent amount | comparative examples 1 | comparative example 2 | Comparative example 3 | comparative example 4 | Comparative example 5 | Comparative example 6 | comparative example 7 | Comparative example 8 | comparative example | Comparative example 10 |
|---|---|---|---|---|---|---|---|---|---|---|---|
| Epoxy resin (A) | 100 | 32.6 | 32.6 | 34.3 | 4.4 | 4.4 | - | - | - | 35.5 | 8.5 |
| Epoxy resin (B 1) | 150 | 3.6 | 3.6 | 3.8 | 39.9 | 39.9 | 26.3 | 4.2 | - | - | 34.1 |
| Epoxy resin (B 2) | 100 | - | - | - | - | - | - | - | - | - | |
| Epoxy resin (B 3) | 189 | - | - | - | - | - | - | - | 50.4 | - | |
| Epoxy resin (B 4) | 160 | - | - | - | - | - | - | - | - | - | |
| Epoxy resin (B 5) | 134 | - | - | - | - | - | 17.5 | 38.2 | - | - | |
| Acid anhydride curing agent (C 1) | 168 | 60.8 | 60.8 | 61.9 | 53.3 | 53.3 | 53.2 | 54.5 | 46.6 | 61.5 | 54.4 |
| Acid anhydride curing agent (C 2) | 164 | - | - | - | - | - | - | - | - | - | |
| Curing accelerator (D) | | 3 | 3 | - | 3 | 3 | 3 | 3 | 3 | 3 | 3 |
| Inorganic filler ( E ) | | 306 | 2448 | 1171 | 747 | 1171 | 747 | 747 | 747 | 747 | 747 |
| Adhesion aid | | 1.5 | 1.5 | 1.5 | 1.5 | 1.5 | 1.5 | 1.5 | 1.5 | 1.5 | 1.5 |
| Pigment | | 0.5 | 0.5 | 0.5 | 0.5 | 0.5 | 0.5 | 0.5 | 0.5 | 0.5 | 0.5 |
| Inorganic filler ( E ) % by mass | | 75 | 96 | 92 | 88 | 92 | 88 | 88 | 88 | 88 | 88 |
| | | | | | | | | | | | |
| Viscosity | Pa·s | 7 | Not kneadable | Curing failure | 180 | Not kneadable | 120 | 90 | 410 | 25 | 60 |
| Tg | °C | 230 | | | 160 | | 155 | 165 | 130 | Molding failure | 165 |
| CTE1 | CTE1 | 22 | | | 9 | | 11 | 12 | 11 | | 11 |
| Wafer warpage | mm | Molding failure | | | 19 | | 30 | 27 | 40 | | 28 |

## Claims

1. A resin composition for semiconductor encapsulation, comprising:
(A) an alicyclic epoxy compound represented by the following formula 1: 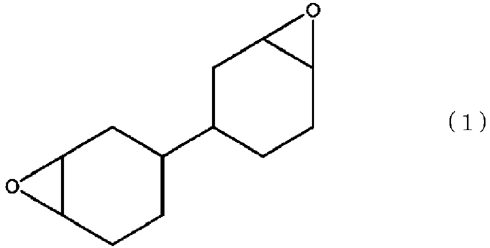
(B) an epoxy resin in the form of a liquid at a room temperature, said epoxy resin being an epoxy resin other than said alicyclic epoxy compound represented by the formula 1;
(C) an acid anhydride curing agent;
(D) a curing accelerator; and
(E) an inorganic filler, wherein
said component (A) is added in an amount of 40 to 90 parts by mass with respect to 100 parts by mass of all the epoxy resins in the total amount of the resin composition, and said component (E) is contained in the total amount of the resin composition by an amount of 80 to 95 % by mass.

2. The resin composition for semiconductor encapsulation according to claim 1, wherein said component (B) is a liquid epoxy resin that does not have a siloxane bond.

3. The resin composition for semiconductor encapsulation according to claim 1 or 2, wherein said component (B) is at least one liquid epoxy resin selected from the group consisting of a liquid bisphenol A-type epoxy resin; a liquid bisphenol F-type epoxy resin; a liquid naphthalene-type epoxy resin; a liquid aminophenol-type epoxy resin; a liquid hydrogenated bisphenol-type epoxy resin; a liquid alcohol ether-type epoxy resin; a liquid cyclic aliphatic epoxy resin; a liquid fluorene-type epoxy resin and a liquid alicyclic epoxy resin represented by the following formula 2: 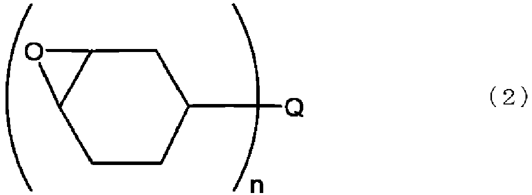 wherein n satisfies n ≥ 2, and Q represents at least one group selected from an n-valent hydrocarbon group having 1 to 30 carbon atoms, an ether bond, an ester bond, a carbonate bond, an amide bond, a carbonyl group and a cyclohexene oxide residue.

4. The resin composition for semiconductor encapsulation according to claim 3, wherein said Q in the formula 2 contains a divalent hydrocarbon group and an ester bond.

5. The resin composition for semiconductor encapsulation according to claim 1, wherein said component (C) is in the form of a liquid at a room temperature.

6. A wafer level package-encapsulation method comprising a step of performing encapsulation through compression-molding, using the resin composition for semiconductor encapsulation as set forth in any of claims 1 to 5.

## Patentansprüche

1. Harzzusammensetzung zur Verkapselung von Halbleitern, umfassend:
(A) eine alicyclische Epoxidverbindung, die durch die folgende Formel 1 dargestellt ist: 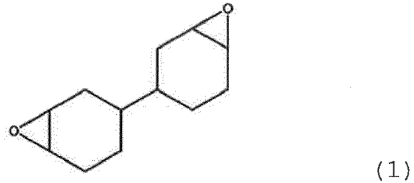
(B) ein Epoxidharz in der Form einer Flüssigkeit bei Raumtemperatur, wobei es sich bei dem Epoxidharz um ein anderes Epoxidharz als die durch die Formel 1 dargestellte alicyclische Epoxidverbindung handelt;
(C) ein Säureanhydrid-Härtungsmittel;
(D) einen Härtungsbeschleuniger und
(E) einen anorganischen Füllstoff, wobei
die Komponente (A) in einer Menge von 40 bis 90 Masseteilen im Verhältnis zu 100 Masseteilen aller Epoxidharze in der Gesamtmenge der Harzzusammensetzung zugegeben ist und die Komponente (E) in der Gesamtmenge der Harzzusammensetzung mit einer Menge von 80 bis 95 Masse-% enthalten ist.

2. Harzzusammensetzung zur Verkapselung von Halbleitern nach Anspruch 1, wobei es sich bei der Komponente (B) um ein flüssiges Epoxidharz handelt, das keine Siloxanbindung aufweist.

3. Harzzusammensetzung zur Verkapselung von Halbleitern nach Anspruch 1 oder 2, wobei es sich bei der Komponente (B) um mindestens ein flüssiges Epoxidharz handelt, das ausgewählt ist aus der Gruppe bestehend aus einem flüssigen Epoxidharz vom Bisphenol-A-Typ, einem flüssigen Epoxidharz vom Bisphenol-F-Typ, einem flüssigen Epoxidharz vom Naphthalen-Typ, einem flüssigen Epoxidharz vom Aminophenol-Typ, einem flüssigen Epoxidharz vom Typ eines hydrogenierten Bisphenols, einem flüssigen Epoxidharz vom Alkoholether-Typ, einem flüssigen cyclischen aliphatischen Epoxidharz, einem flüssigen Epoxidharz vom Fluoren-Typ und einem flüssigen alicyclischen Epoxidharz, dargestellt durch die folgende Formel 2 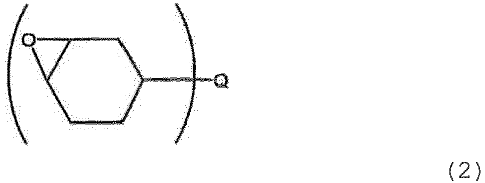 wobei n n ≥ 2 erfüllt und Q mindestens eine Gruppe ausgewählt aus einer n-valenten Kohlenwasserstoffgruppe mit 1 bis 30 Kohlenstoffatomen, einer Etherbindung, einer Esterbindung, einer Carbonatbindung, einer Amidbindung, einer Carbonylgruppe und einem Cyclohexenoxidrest darstellt.

4. Harzzusammensetzung zur Verkapselung von Halbleitern nach Anspruch 3, wobei Q in der Formel 2 eine divalente Kohlenwasserstoffgruppe und eine Esterbindung enthält.

5. Harzzusammensetzung zur Verkapselung von Halbleitern nach Anspruch 1, wobei die Komponente (C) bei Raumtemperatur in der Form einer Flüssigkeit vorliegt.

6. Wafer-Level-Package-Verkapselungsverfahren, umfassend einen Schritt der Durchführung einer Verkapselung durch Formpressen unter Verwendung der Harzzusammensetzung zur Verkapselung von Halbleitern, wie sie in den jeglichem der Ansprüche 1 bis 5 ausgeführt ist.

## Revendications

1. Composition de résine pour encapuslation de semi-conducteur, comprenant :
(A) un composé époxy alicyclique représenté par la formule (1) suivante : 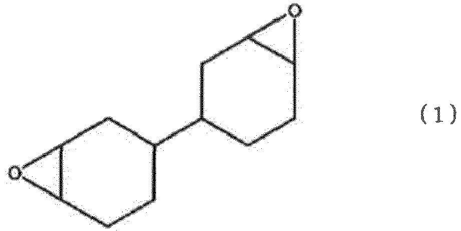
(B) une résine époxy sous la forme d'un liquide à température ambiante, ladite résine époxy étant une résine époxy autre que ledit composé époxy alicyclique représenté par la formule (1) ;
(C) un agent de durcissement de type anhydride acide ;
(D) un accélérateur de durcissement ; et
(E) une charge inorganique,
dans laquelle ledit composant (A) est ajouté en une quantité de 40 à 90 parties en masse par rapport à 100 parties en masse de toutes les résines époxy dans la quantité totale de la composition de résine, et ledit composant (E) est contenu dans la quantité totale de la composition de résine, en une quantité de 80 à 95 % en masse.

2. Composition de résine pour encapuslation de semi-conducteur selon la revendication 1, dans laquelle ledit composant (B) est une résine époxy liquide qui ne comprend pas de liaison siloxane.

3. Composition de résine pour encapuslation de semi-conducteur selon la revendication 1 ou 2, dans laquelle ledit composant (B) est au moins une résine époxy liquide sélectionnée dans le groupe constitué par une résine époxy de type bisphénol A liquide ; une résine époxy de type bisphénol F liquide ; une résine époxy de type naphtalène liquide ; une résine époxy de type aminophénol liquide ; une résine époxy de type bisphénol hydrogéné liquide ; une résine époxy de type éther d'alcool liquide ; une résine époxy aliphatique cyclique liquide ; une résine époxy de type fluorène liquide et une résine époxy alicyclique liquide représentée par la formule (2) suivante : 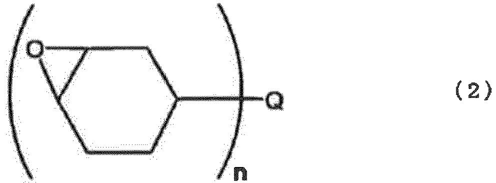 dans laquelle n satisfait à n ≥ 2 et Q représente au moins un groupe sélectionné parmi un groupe hydrocarboné de valence n ayant de 1 à 30 atomes de carbone, une liaison éther, une liaison ester, une liaison carbonate, une liaison amide, un groupe carbonyle et un résidu oxyde de cyclohexène.

4. Composition de résine pour encapuslation de semi-conducteur selon la revendication 3, dans laquelle ledit Q dans la formule (2) comprend un groupe hydrocarboné divalent et une liaison ester.

5. Composition de résine pour encapuslation de semi-conducteur selon la revendication 1, dans laquelle ledit composant (C) est sous la forme d'un liquide à température ambiante.

6. Procédé d'encapsulation d'emballage au niveau de la tranche comprenant une étape consistant à réaliser une encapsulation par moulage par compression, en utilisant la composition de résine pour encapuslation de semi-conducteur telle que définie selon l'une quelconque des revendications 1 à 5.
